# EUROPEAN PATENT APPLICATION

(11) **EP 4 421 810 A1**
(43) Date of publication of application: **28.08.2024**
(21) Application number: 24158555.3
(22) Date of filing: 20.02.2024
(51) Int. Cl.: G11C 16/08, G11C 16/04, G11C 16/26, G11C 16/34, G11C 8/08, G11C 29/02, G11C 29/04

(54) **FLASH MEMORY AND READ RECOVERY METHOD THEREOF**

(30) Priority: 24.02.2023 KR 20230025254
(71) Applicant: Samsung Electronics Co., Ltd., Suwon-si, Gyeonggi-do 16677 (KR)
(72) Inventor: KIM, Byungsoo, 16677 Suwon-si, Gyeonggi-do (KR); KIM, Jinsu, 16677 Suwon-si, Gyeonggi-do (KR); KIM, Hyunggon, 16677 Suwon-si, Gyeonggi-do (KR)
(74) Representative: Kuhnen & Wacker Patent- und Rechtsanwaltsbüro PartG mbB

(57) **Abstract**

A flash memory comprises a memory cell array (1110) having a plurality of memory cells (MC1 to MCm); a read recovery voltage generator (1155) configured to provide a read recovery voltage (Vrcv) to the plurality of memory cells (MC1 to MCm); and a read recovery voltage controller (2000) configured to provide recovery control signals (CTRL) for controlling the read recovery voltage (Vrcv). The read recovery voltage generator (1155) includes a plurality of ground pass transistors that during a read recovery operation are configured to control a falling slope of an unselection recovery voltage (uVrcv) provided to an unselected word line (uWL) in response to the recovery control signals (CTRL).

## Description

### BACKGROUND

Various example embodiments described herein relate to a semiconductor memory device, and more particularly, to a flash memory and/or a read recovery method thereof.

Semiconductor memories may be classified as a volatile memory or a non-volatile memory, for example. Typically, the volatile memories (e.g., a dynamic random access memory (DRAM) or a static random access memory (SRAM)) may exhibit faster read and/or write speeds when compared to the non-volatile memory. However, data stored in the volatile memory may disappear when a power applied to the volatile memory is turned off. In contrast, the non-volatile memory may retain the data even when the power is turned off.

A representative example of the non-volatile memory may be or include a flash memory. The flash memory may be used as a storage device for electronic devices such as, but not limited to, computers, smart phones, digital cameras and the like. The flash memory may store single-bit data or multi-bit data of two or more bits in one memory cell. The flash memory may have at least one erase state and a plurality of program (e.g., writing) states depending on threshold voltage distributions.

The flash memory advantageously has a sufficient read margin between each program state. However, the threshold voltage of the flash memory may change due to various reasons during a program and/or read operation. As threshold voltages of memory cells increase, the erase state may overlap or at least partially overlap the program state. As a result, a read fail may occur during a read operation. Threshold voltage of memory cells may change due to one or more of coupling noise, program disturbance, read disturbance, hot carrier injection (HCI), and the like.

After a read recovery operation of the flash memory, a residual voltage may exist between a selected word line and the unselected word lines. In particular, a larger residual voltage skew may occur between the selected word line and an adjacent word line. Threshold voltage distortion may occur due to residual voltage skew.

### SUMMARY

Various example embodiments provide a flash memory that may reduce threshold voltage distortion caused by a residual voltage skew between the selected word line and unselected word lines after a read recovery operation.

According to some example embodiments, a flash memory comprises a memory cell array having a plurality of memory cells; a read recovery voltage generator configured to provide a read recovery voltage to the plurality of memory cells; and a read recovery voltage controller configured to provide recovery control signals for controlling the read recovery voltage. The read recovery voltage generator includes a plurality of transistors that are configured to control a slope of a recovery voltage provided to a word line in response to the recovery control signals during a read recovery operation. The read recovery voltage controller is configured to control a slope of a selection recovery voltage provided to a selected word line and an unselection recovery voltage provided to unselected word lines so as to be different.

Alternatively or additionally according to various example embodiments, a flash memory comprises a memory cell array having a plurality of memory cells; a read recovery voltage generator configured to provide a read recovery voltage to the plurality of memory cells; and a read recovery voltage controller configured to provide recovery control signals for controlling the read recovery voltage. The read recovery voltage generator includes a plurality of transistors that are configured to control a slope of a recovery voltage provided to a word line in response to the recovery control signals during a read recovery operation, and the read recovery voltage controller is configured to control a slope of a selection recovery voltage provided to a selected word line and an unselection recovery voltage provided to unselected word lines so as to be different.

Alternatively or additionally according to various example embodiments, a read recovery operation method of a flash memory which includes a memory cell array having a plurality of memory cells, a read recovery voltage generator that is configured to provide a read recovery voltage to the plurality of memory cells, and a read recovery voltage controller that is configured to provide recovery control signals for controlling the read recovery voltage, comprises providing in a post pulse period a selection recovery voltage having a rising slope to a selected word line and providing an adjacent recovery voltage having a falling slope to an adjacent word line adjacent to the selected word line; providing in a first recovery period an unselection recovery voltage having a falling slope to an unselected word line excluding the adjacent word line; and in a second recovery period controlling the selection recovery voltage, the unselection recovery voltage, and the adjacent recovery voltage to have a recovery voltage.

Additional aspects will be set forth in part in the description which follows and, in part, will be apparent from the description, or may be learned by practice of the presented embodiments.

### BRIEF DESCRIPTION OF THE FIGURES

The above and other objects and features will become apparent by describing in detail embodiments thereof with reference to the accompanying drawings.
FIG. 1 is a block diagram illustrating a storage device according to some example embodiments.
FIG. 2 is a block diagram illustrating the flash memory illustrated in FIG. 1 according to various example embodiments.
FIG. 3 is a circuit diagram illustrating a memory block BLK1 of the memory cell array illustrated in FIG. 2 according to various example embodiments.
FIG. 4 is a circuit diagram illustrating cell strings selected by the first string selection line SSL1 from among the cell strings of the memory block BLK1 illustrated in FIG. 3 according to various example embodiments.
FIG. 5 is a diagram illustrating threshold voltage distributions of memory cells illustrated in FIG. 4 according to various example embodiments.
FIG. 6 is a timing diagram illustrating a read operation method of a flash memory according to a comparative example.
FIG. 7 is a block diagram illustrating the word line voltage generator and the read recovery voltage controller illustrated in FIG. 2 according to various example embodiments.
FIG. 8 is a block diagram illustrating the read recovery voltage generator illustrated in FIG. 7 according to various example embodiments.
FIG. 9 is a timing diagram illustrating a read operation method of the flash memory illustrated in FIG. 1 according to various example embodiments.
FIG. 10 is a diagram illustrating a flash memory having a multi-stack structure according to various example embodiments.
FIG. 11 is a cross-sectional view illustrating a flash memory having a COP structure according to various example embodiments.
FIG. 12 is a view illustrating a memory device according to some embodiments.

### DETAILED DESCRIPTION

Below, example embodiments will be described in detail and clearly to such an extent that an ordinary one in the art may easily implement inventive concepts.

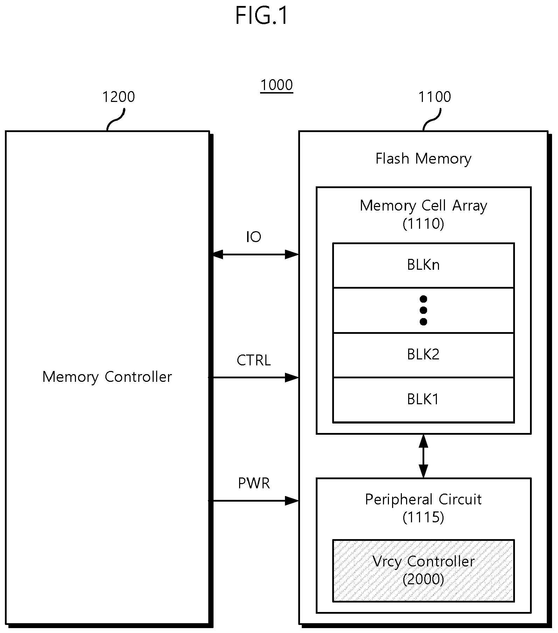

FIG. 1 is a block diagram illustrating a storage device according to various example embodiments . The storage device 1000 may be a flash storage device based on the flash memory 1100. For example, the storage device 1000 may be implemented as and/or include or be included in one or more of a solid-state drive (SSD), universal flash storage (UFS), a memory card, or the like.

Referring to FIG. 1, the storage device 1000 may include a flash memory 1100 and a memory controller 1200. The flash memory 1100 may receive input/output signals IO from the memory controller 1200 through input/output lines, may receive control signals CTRL through control lines, and may receive external power supply PWR through power lines. The storage device 1000 may store data in the flash memory 1100 under the control of the memory controller 1200.

The flash memory 1100 may include a memory cell array 1110 and a peripheral circuit 1115. The memory cell array 1110 may include a plurality of memory blocks BLK1 to BLKn. Each memory block may have a vertical 3D structure. Each memory block may include a plurality of memory cells. Single-bit data and/or multi-bit data may, such as but not limited to two-level data (MLC) or three-level data (TLC) may be stored in each memory cell.

The memory cell array 1110 may be located (e.g., disposed) next to and/or above the peripheral circuit 1115 in terms of the design layout structure. A structure in which the memory cell array 1110 is positioned over the peripheral circuit 1115 may be referred to as a cell-on-peripheral (COP) structure.

In some example embodiments, the memory cell array 1110 may be manufactured as a chip separate from the peripheral circuit 1115. An upper chip including the memory cell array 1110 and a lower chip including the peripheral circuit 1115 may be connected to each other by a bonding method. Such a structure may be referred to as a chip-to-chip (C2C) structure.

The peripheral circuit 1115 may include all analog circuits and/or digital circuits that are required or used to store data in the memory cell array 1110 or read data stored in the memory cell array 1110. The peripheral circuit 1115 may receive the external power PWR through power lines and generate internal powers of various levels.

The peripheral circuit 1115 may receive commands, addresses, and/or data from the memory controller 1200 through input/output lines. The peripheral circuit 1115 may store data in the memory cell array 1110 according to the control signals CTRL. Alternatively or additionally, the peripheral circuit 1115 may read data stored in the memory cell array 1110 and provide the read data to the memory controller 1200.

The peripheral circuit 1115 may include a read recovery voltage controller 2000. The read recovery voltage controller 2000 may control the recovery voltage Vrcy during a read operation. The read recovery voltage controller 2000 may control a slope and/or a duration of a read recovery voltage provided to a selected word line and/or to unselected word lines. The read recovery voltage controller 2000 may control the recovery voltage during a read operation so as to reduce a residual voltage between a selected word line and unselected word lines after a recovery operation. According to various example embodiments, threshold voltage distortion that may occur due to residual voltage skew that may occur during a read recovery operation may be reduced.

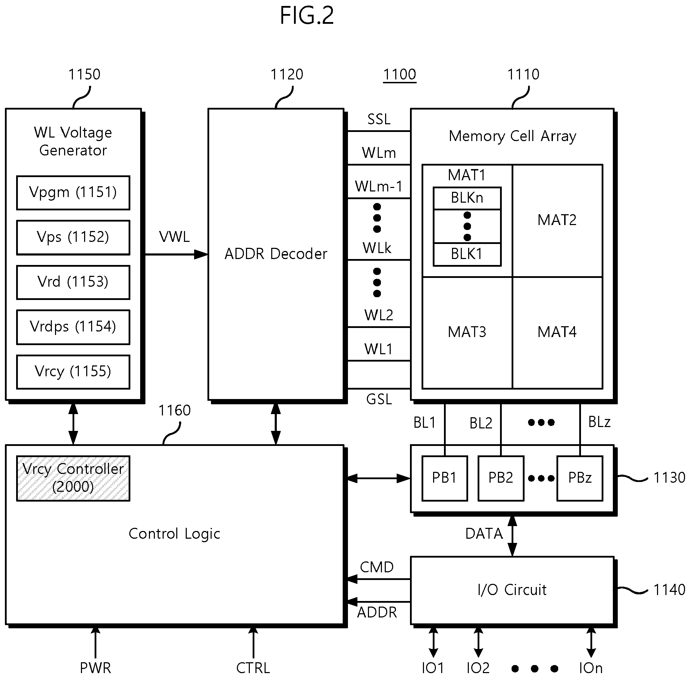

FIG. 2 is a block diagram illustrating the flash memory illustrated in FIG. 1 according to various example embodiments. Referring to FIG. 2, the flash memory 1100 may include a memory cell array 1110, an address decoder 1120, a page buffer circuit 1130, a data input/output circuit 1140, a word line voltage generator 1150, and a control logic 1160.

The memory cell array 1110 may include a plurality of mats (e.g., MAT1 to MAT4). Each mat may include a plurality of memory blocks. For example, the first mat MAT1 may include the first to n-th memory blocks BLK1 to BLKn. Different mats may include the same number, or different number, of memory blocks. Each memory block may be composed of or may include a plurality of pages. Different memory blocks may include the same number, or a different number, of pages. Each page may include a plurality of memory cells. Each memory cell may store multi-bit data (e.g., two or more bits). Each memory block may correspond to an erase unit, and each page may correspond to a read and/or write unit. There may be dummy mats and/or dummy memory blocks and/or redundancy mats and/or redundancy memory blocks (not illustrated); example embodiments are not limited thereto.

The memory cell array 1110 may be formed or arranged in a direction perpendicular to a substrate. A gate electrode layer and an insulation layer may be alternately deposited on the substrate. Each memory block (e.g., BLK1) may be connected to one or more string selection lines SSL, a plurality of word lines WL1 to WLm, and one or more ground selection lines GSL.

The address decoder 1120 may be connected to the memory cell array 1110 through selection lines SSL and GSL and word lines WL1 to WLm. In various example embodiments, m may be greater than, less than, or equal to n. The address decoder 1120 may select a word line during a program or read operation. The address decoder 1120 may receive the word line voltage VWL from the word line voltage generator 1150 and provide a program voltage or read voltage to the selected word line.

The page buffer circuit 1130 may be connected to the memory cell array 1110 through bit lines BL1 to BLz. The page buffer circuit 1130 may store (e.g., temporarily) store data to be stored in the memory cell array 1110 and/or data read from the memory cell array 1110. The page buffer circuit 1130 may include page buffers PB1 to PBz connected to respective bit lines. Each page buffer may include a plurality of latches (e.g., flip-flops) to store or read multi-bit data.

The input/output circuit 1140 may be internally connected to the page buffer circuit 1130 through data lines and externally connected to the memory controller (refer to FIG. 1, 1200) through the input/output lines IO1 to IOn. The input/output circuit 1140 may receive program data from the memory controller 1200 during a program operation. Alternatively or additionally, the input/output circuit 1140 may provide data read from the memory cell array 1110 to the memory controller 1200 during a read operation.

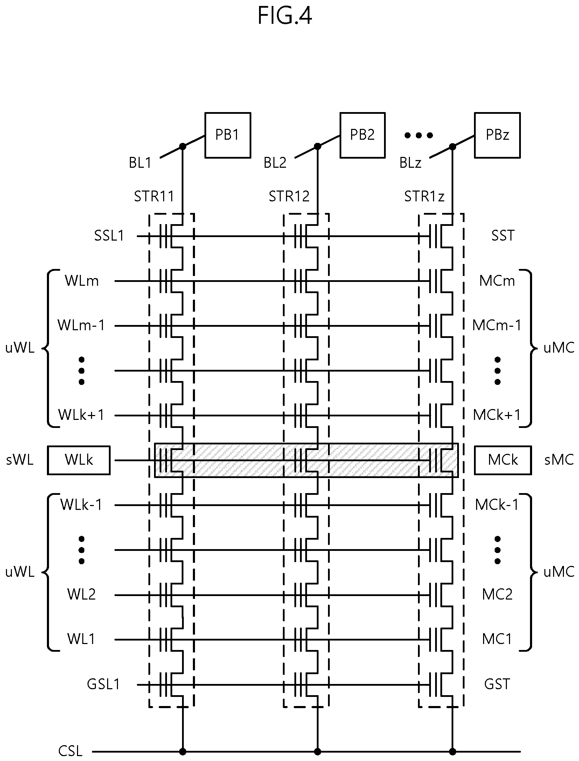

The word line voltage generator 1150 may receive internal power from the control logic 1160 and may generate a word line voltage VWL required or used to read and/or write data. The word line voltage VWL may be provided to a selected word line sWL and/or unselected word lines uWL (see FIG. 4) through the address decoder 1120.

The word line voltage generator 1150 may include a program voltage generator 1151, a pass voltage generator 1152, a read voltage generator 1153, and a read pass voltage generator 1154. The program voltage generator 1151 may generate a program voltage Vpgm provided to the selected word line sWL during a program operation. The pass voltage generator 1152 may generate a pass voltage Vps provided to the unselected word lines uWL. The read voltage generator 1153 may generate the selection read voltage Vrd provided to the selected word line sWL during a read operation. The read pass voltage generator 1154 may generate a read pass voltage Vrdps provided to the unselected word lines uWL. The read pass voltage Vrdps and/or the pass voltage Vps may be a voltage sufficient to turn on memory cells that are connected to the unselected word lines uWL during a read operation. The word line voltage generator 1150 may further include a read recovery voltage generator 1155. The read recovery voltage generator 1155 may generate a recovery voltage Vrcy provided to the selected word line sWL or unselected word lines uWL during a read operation. A read operation of the flash memory 1100 may be divided into a sensing period and a recovery period. The word line voltage generator 1150 may provide the selection read voltage Vrd to the selected word line sWL in the sensing period and provide the pass voltage Vps or read pass voltage Vrdps to the unselected word lines uWL.

In some example embodiments, any of or at least one of the program voltage Vpgm, the pass voltage Vps, the read voltage Vrd, the read pass voltage Vrdps, or the recovery voltage Vrcy may be voltages that are generated within the word line voltage generator 1150. In some example embodiments, the word line voltage generator 1150 may include a capacitor such as a high-capacitance capacitor (not illustrated) that generates or helps to generate the respective voltages. However, example embodiments are not limited thereto.

The control logic 1160 may control operations such as one or more of read, write, and erase of the flash memory 1100 using one or more of commands CMD, addresses ADDR, and control signals CTRL provided from the memory controller 1200. The addresses ADDR may include a block selection address for selecting one memory block, a row address for selecting one page, and a column address for selecting one memory cell.

The control logic 1160 may include a read recovery voltage controller 2000. The read recovery voltage controller 2000 may control a recovery voltage provided to a selected word line and/or unselected word lines during a read operation. The read recovery voltage controller 2000 may reduce a residual voltage between the selected word line and/or the unselected word lines after a recovery operation.

The flash memory 1100 may include a separate word line voltage generator 1150 for each mat; however, example embodiments are not limited thereto. The flash memory 1100 may differently control a read recovery operation for each mat. According to various example embodiments, threshold voltage distortion that may occur due to residual voltage skew that may occur during a read recovery operation may be reduced.

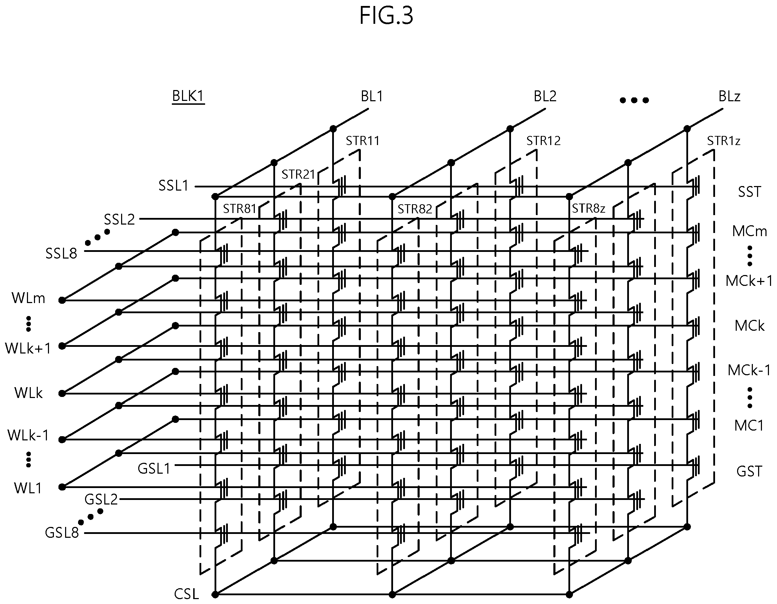

FIG. 3 is a circuit diagram illustrating a memory block BLK1 of the memory cell array illustrated in FIG. 2 according to various example embodiments. Referring to FIG. 3, in the memory block BLK1, a plurality of cell strings STR11 to STR8z may be formed between the bit lines BL1 to BLz and a common source line CSL. Each cell string includes a string selection transistor SST, a plurality of memory cells MC1 to MCm, and a ground selection transistor GST.

The string selection transistors SST may be connected with a number, such as eight string selection lines SSL1 to SSL8. The ground selection transistors GST may be connected with a number, such as eight, ground selection lines GSL1 to GSL8. The string selection transistors SST may be connected with the bit lines BL1 to BLz, and the ground selection transistors GST may be connected with the common source line CSL.

The first to m-th word lines WL1 to WLm may be connected with the plurality of memory cells MC1 to MCm in a row direction. The first to z-th bit lines BL1 to BLz may be connected with the plurality of memory cells MC1 to MCm in a column direction. First to z-th page buffers PB1 to PBz may be connected with the first to z-th bit lines BL1 to BLz. In various example embodiments, m may be greater than, less than, or equal to z.

The first word line WL1 may be placed above the first to eighth ground selection lines GSL1 to GSL8. The first memory cells MC1 that are placed at the same height from the substrate may be connected with the first word line WL1. In a similar manner, the second to m-th memory cells MC2 to MCm that are placed at the same heights from the substrate may be respectively connected with the second to eighth word lines WL2 to WLm.

FIG. 4 is a circuit diagram illustrating cell strings selected by the first string selection line SSL1 from among the cell strings of the memory block BLK1 illustrated in FIG. 3 according to various example embodiments. The (1,1)th to (1,z) cell strings STR11 to STR1z may be selected by the first string selection line SSL1. The (1,1)th to (1,z) cell strings STR11 to STR1z may be connected to the first to z -th bit lines BL1 to BLz, respectively. The first to z-th page buffers PB1 to PBz may be connected to the first to z-th bit lines BL1 to BLz, respectively.

The (1.1)th cell string STR11 may be connected to the first bit line BL1 and the common source line CSL. The (1,1)th cell string STR11 may include string selection transistors SST selected by the first string selection line SSL1, first to m-th memory cells MC1 to MCm connected to the first to m-th word lines WL1 to WLm, and ground selection transistors GST selected by the first ground selection line GSL1. The (1,2)th cell string STR12 may be connected to the second bit line BL2 and the common source line CSL. The (1z) cell string STR1z may be connected to the z-th bit line BLz and the common source line CSL.

The first word line WL1 and the m-th word line WLm may be edge word lines (edge WL). The second word line WL2 and the (m-1)-th word line WLm-1 may be edge adjacent word lines. The k-th word line WLk may be a selected word line sWL. The (k-1)-th word line WLk-1 and the (k+1)-th word line WLk+1 may be adjacent word lines adjacent to the selected word line. If the k-th word line WLk is the selected word line sWL, the remaining word lines WL1 to WLk-1 and WLk+1 to WLm may be unselected word lines uWL, e.g., word lines that are not to be read and/or programmed and/or erased.

The first memory cells MC1 and the m-th memory cells MCm may be edge memory cells. The second memory cells MC2 and the (m-1)-th memory cells MCm-1 may be edge adjacent memory cells. The k-th memory cells MCk may be selected memory cells sMC. The (k-1)-th memory cells MCk-1 and the (k+1)-th memory cells MCk+1 may be memory cells adj acent to the selected memory cells (adj acent MC). If the k-th memory cells MCk are selected memory cells sMC, the remaining memory cells MC1 to MCk-1 and MCk+1 to MCm may be unselected memory cells uMC.

A set of memory cells selected by one string selection line and connected to one word line may be or may correspond to one page. For example, memory cells selected by the first string selection line SSL1 and connected to the k-th word line WLk may be one page. For example, eight, less than eight, or more than eight pages may be configured on the k-th word line WLk. Among the eight pages, a page connected to the first string selection line SSL1 is a selected page, and pages connected to the second to eighth string selection lines SSL2 to SSL8 are unselected pages.

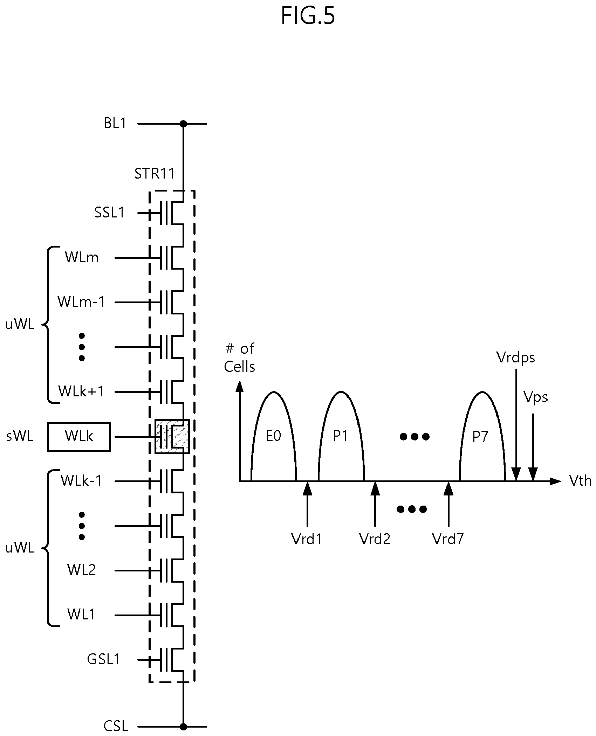

FIG. 5 is a diagram illustrating threshold voltage distributions of memory cells illustrated in FIG. 4 according to various example embodiments. The horizontal axis represents the threshold voltage Vth, and the vertical axis represents the number of memory cells (arbitrary units).

FIG. 5 shows an example in which 3-bit data (TLC) is stored in one memory cell. A 3-bit memory cell may have one of eight states (E0, P1 to P7) according to the threshold voltage distribution. E0 represents an erase state, and P1 to P7 represent program states.

During a read operation, the selection read voltages Vrd1 to Vrd7 may be provided to the selected word line sWL, and the pass voltage Vps and/or the read pass voltage Vrdps may be provided to the unselected word lines uWL. The pass voltage Vps and/or the read pass voltage Vrdps may be a voltage sufficient to turn on the memory cells.

The first selection read voltage Vrd1 may be a voltage level that is between the erase state E0 and the first program state P1. The second selection read voltage Vrd2 may be a voltage level between the first and second program states P1 and P2. In this way, the seventh selection read voltage Vrd7 may be a voltage level between the sixth and seventh program states P6 and P7.

When the first selection read voltage Vrd1 is applied, the memory cell in the erase state E0 may be an "on" cell and the memory cell in the first to seventh program states P1 to P7 may be an "off' cell. When the second selection read voltage Vrd2 is applied, the memory cell in the erase state E0 and the first program state P1 may an "on" cell, and the memory cell in the second to seventh program states P2 to P7 may an "off' cell. In this way, when the seventh selection read voltage Vrd7 is applied, the memory cell in the erase state E0 and the first to sixth program states P1 to P6 may be an "on" cell and the memory cell in the seventh program state P7 may be an "off' cell.

During a read operation, the k-th word line WLk may be selected. A power supply voltage may be applied to the string selection line SSL1 and the ground selection line GSL1, and the string select transistor SST and the ground select transistor GST may be turned on. Also, the selection read voltage Vrd may be provided to the selected word line sWL, and the read pass voltage Vrdps may be provided to the unselected word lines uWL.

When the read operation of the k-th word line WLk is repeatedly performed, the high voltage read pass voltage Vrdps may be repeatedly provided to the remaining word lines. At this time, a read disturbance may occur in the remaining word lines, and thus the threshold voltage may be distorted. Memory cells connected to the k-th word line WLk may be "off' cells when a selection read voltage is provided. For example, when the threshold voltage of the k-th memory cell is higher than the selection read voltage, the k-th memory cell may be an "off' cell. When the k-th memory cell is an "off' cell, a channel may be separated at the k-th memory cell. For example, a lower channel of the k-th memory cell may receive a ground voltage from the common source line CSL, and an upper channel of the k-th memory cell may have a negative channel voltage Vneg.

A channel voltage difference may occur between a lower channel and an upper channel with the k-th memory cell interposed therebetween. Due to the channel voltage difference, hot carrier injection (HCI) may occur in an adjacent memory cells MCk+1 and/or MCk-1. For this reason, threshold voltages of memory cells connected to adjacent word lines WLk+1 and/or WLk-1 may be distorted. For example, the threshold voltages of memory cells in the erased state E0 may rise to enter a programmed state (e.g., the lowest program state). This distortion may lead to read errors.

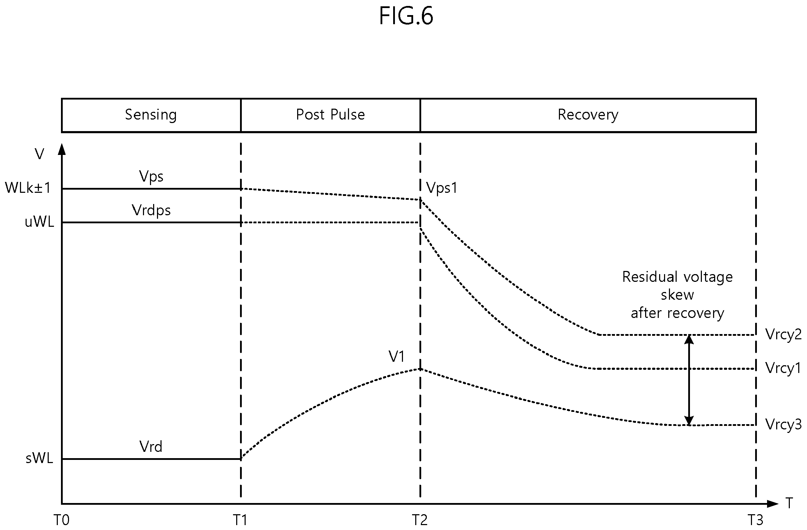

FIG. 6 is a timing diagram illustrating a a read operation method of a flash memory, e.g., of a comparative flash memory, according to various example embodiments. Referring to FIG. 6, the read operation of the flash memory 1100 may include a sensing period, a post pulse period, and a recovery period. The sensing period is a period T0 to T1, the post pulse period is a period T1 to T2, and the recovery period is a period T2 to T3. As illustrated, each of the sensing period, the post pulse period, and the recovery period are immediately sequential; example embodiments are not necessarily limited thereto.

In the sensing period, the selection read voltage Vrd is provided to the selected word line sWL, the read pass voltage Vrdps is provided to the unselected word lines uWL, and the adjacent word lines WLk+1 and/or WLk-1 is provided with a pass voltage Vps. A selection line voltage is applied to the string selection line SSL and the ground selection line GSL. The selection line voltage may be a voltage sufficient to turn on the string selection transistor SST and the ground selection transistor GST.

In the post pulse period, the selection read voltage Vrd provided to the selected word line sWL may rise (e.g., linearly or curvedly rise) to the first voltage V1. The read pass voltage Vrdps is provided to the unselected word lines uWL, and the pass voltage Vps or a first pass voltage Vps1 slightly lower than the pass voltage Vps may be provided to the adjacent word line WLk+1 and/or WLk-1.

In the recovery period, a voltage level of the string selection line SSL and/or the ground selection line GSL may be lowered to the ground voltage. The unselected word lines uWL, the adjacent word lines WLk+1 and/or WLk-1, and the selected word line sWL may be lowered to a first recovery voltage Vrcy1, a second recovery voltage Vrcy2, and a third recovery voltage Vrcy3, respectively.

As illustrated in FIG. 6, a residual voltage (Vrcy1-Vrcy3) may exist between the selected word line sWL and unselected word lines uWL after the read recovery operation. In particular, in the flash memory, a larger residual voltage (Vrcy2-Vrcy1) may exist between the selected word line sWL and the adjacent word line WLk+1 and/or WLk-1. Threshold voltage distortion may occur due to residual voltage skew.

The flash memory 1100 according to various example embodiments may include a read recovery voltage controller 2000 to reduce residual voltage skew that may occur after the read recovery operation. The read recovery voltage controller 2000 may control recovery voltages provided to a selected word line and/or unselected word lines during a read operation. The read recovery voltage controller 2000 may reduce a residual voltage between the selected word line and the unselected word lines after the recovery operation.

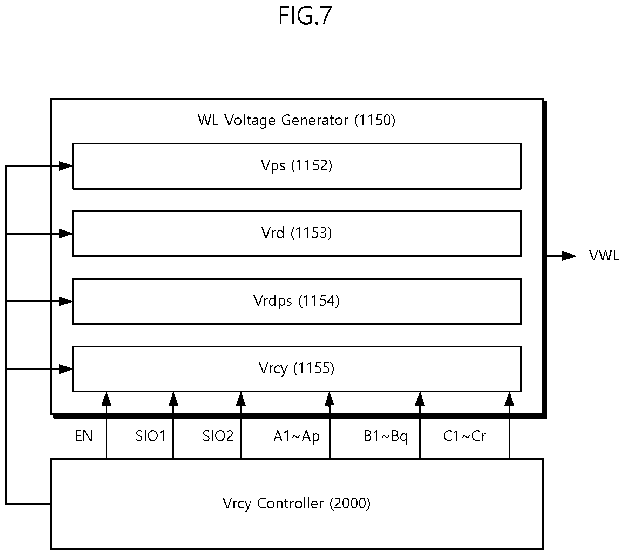

FIG. 7 is a block diagram illustrating the word line voltage generator and the read recovery voltage controller illustrated in FIG. 2 according to various example embodiments. Referring to FIG. 7, the word line voltage generator 1150 may include a pass voltage generator 1152, a read voltage generator 1153, a read pass voltage generator 1154, and a recovery voltage generator 1155.

The pass voltage generator 1152 may generate a pass voltage Vps provided to the unselected word lines uWL. The read voltage generator 1153 may generate the selection read voltage Vrd provided to the selected word line sWL during a read operation. The read pass voltage generator 1154 may generate a read pass voltage Vrdps provided to the unselected word lines uWL. The read recovery voltage generator 1155 may generate a recovery voltage Vrcy provided to the selected word line sWL and/or unselected word lines uWL during a read operation.

A read operation of the flash memory 1100 may be divided into or partitioned into a sensing period, a post pulse period, and a recovery period. The word line voltage generator 1150 may provide the selection read voltage Vrd to the selected word line sWL in the sensing period and may provide the pass voltage Vps and/or read pass voltage Vrdps to the unselected word lines uWL. The word line voltage generator 1150 may provide the post pulse voltage to the selected word line sWL and the unselected word lines uWL in the post pulse period and provide the recovery voltage in the recovery period.

The read recovery voltage controller 2000 may control a post pulse voltage and a recovery voltage provided to a selected word line and/or unselected word lines during the read operation. The read recovery voltage controller 2000 may control the pass voltage generator 1152, the read voltage generator 1153, the read pass voltage generator 1154, and the read recovery voltage generator 1155. The read recovery voltage controller 2000 may control the post pulse voltage and the read recovery voltage. A read recovery voltage may be a recovery voltage provided to a selected word line and/or unselected word lines during the read operation.

The read recovery voltage controller 2000 may provide recovery control signals to the read recovery voltage generator 1155. The recovery control signals may include an enable signal EN, first and second SIO signals SIO1 and SIO2, and power control signals A1 to Ap, B1 to Bq, and C1 to Cr. The read recovery voltage controller 2000 may reduce a residual voltage between a selected word line and unselected word lines after the recovery operation by using recovery control signals. A residual voltage skew may occur during the read recovery operation. Threshold voltage distortion may occur due to the residual voltage skew. The flash memory 1100 according to various example embodiments may reduce threshold voltage distortion due to the residual voltage skew.

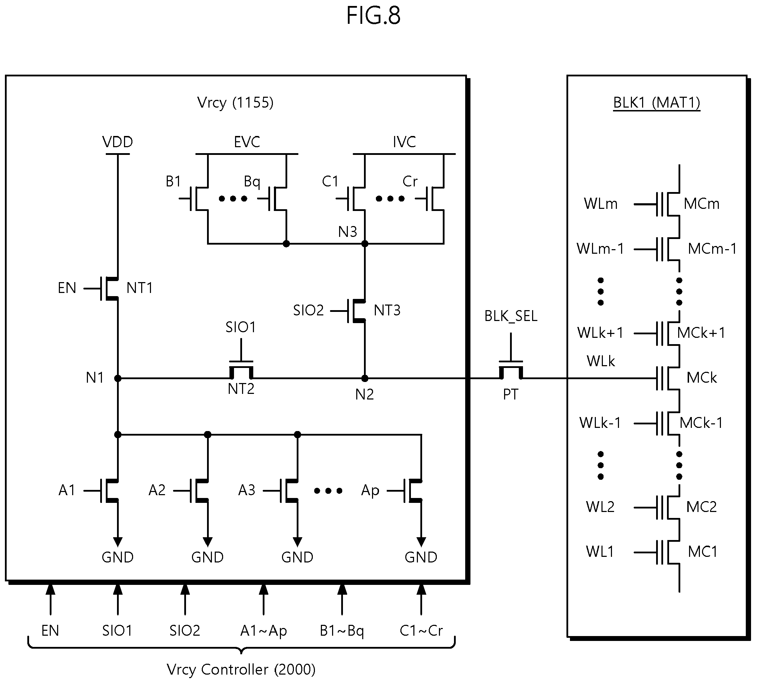

FIG. 8 is a block diagram illustrating the read recovery voltage generator illustrated in FIG. 7 according to various example embodiments. Referring to FIG. 8, the read recovery voltage generator 1155 may be connected to the first memory block BLK1 of the first mat MAT1 through a block selection circuit. The block selection circuit may operate according to the block selection signal BLK_SEL. The block selection circuit may include a high voltage pass transistor PT.

The read recovery voltage generator 1155 may include a power terminal, for example an external power terminal and/or an internal power terminal. The read recovery voltage generator 1155 may include a power voltage VDD supply, an external voltage EVC supply, an internal voltage IVC supply, and a ground voltage GND supply, which may be connected to a corresponding power terminal. The external voltage EVC supply may be connected to an external power terminal, and the internal voltage IVC supply may be connected to an internal power supply. A first transistor such as a first NMOS transistor NT1 may be included between the first node N1 and the VDD supply. The first NMOS transistor NT1 may provide the power voltage VDD to the first node N1 according to the enable signal EN. The first NMOS transistor NT1 may be or may include a transistor having high voltage durability. In some example embodiments, the first NMOS transistor may be thick-oxide transistor; however, example embodiments are not limited thereto.

A plurality of ground pass transistors may be included between the first node N1 and the ground voltage GND supply. The plurality of ground pass transistors may be transistors having high voltage durability. In some example embodiments, the plurality of ground pass transistors may be thick-oxide transistors; however, example embodiments are not limited thereto. The plurality of ground pass transistors may be connected in parallel. The plurality of ground pass transistors may provide the ground voltage GND to the first node N1 according to the ground control signals A1 to Ap. Although the plurality of ground pass transistors are illustrated as being NMOS transistors, example embodiments are not limited thereto.

The plurality of ground pass transistors may be used to adjust the falling slope of the recovery voltage. The read recovery voltage controller 2000 may provide ground control signals A1 to Ap (which are an example of recovery control signals) to the read recovery voltage generator 1155 during the recovery operation. The read recovery voltage generator 1155 may control a falling slope of the recovery voltage provided to the selected word line sWL and/or unselected word lines uWL during the recovery operation period. Note that for reasons of clarity, only the connection to the selected word line sWL (WLk) is shown. However, similar connections may be formed with respect to the unselected word lines uWLs (WLk1 to WLk-1, WLk+1 to Wlm). The read recovery voltage controller 2000 may adjust the number of ground pass transistors having discharge paths to the ground terminal. In some example embodiments, the vector of ground control signals A1 to Ap may determine the number of ground pass transistors having discharge paths to the ground terminal. The read recovery voltage controller 2000 may control a falling slope of the recovery voltage according to the number of pass transistors having discharge paths.

A second transistor such as a second NMOS transistor NT2 may be included between the first node N1 and the second node N2. The second NMOS transistor NT2 may electrically connect the first node N1 and the second node N2 according to the first SIO signal SIO1. The second NMOS transistor NT2 may be a transistor having high voltage durability. The second NMOS transistor NT2 may be a thick gate-oxide transistor; however, example embodiments are not limited thereto.

A third transistor such as a third NMOS transistor NT3 may be included between the second node N2 and the third node N3. The third NMOS transistor NT3 may electrically connect the second node N2 and the third node N3 according to the second SIO signal SIO2. The third NMOS transistor NT3 may be a transistor having high voltage durability. The third NMOS transistor NT3 may be thick gate-oxide transistor; however, example embodiments are not limited thereto.

A plurality of external power control transistors or power transistors or voltage EVC transistors may be included between the third node N3 and the external voltage EVC supply or the external power terminal. The plurality of EVC transistors may be connected in parallel. The plurality of EVC transistors may provide the external voltage EVC to the third node N3 according to the EVC control signals B1 to Bq (which are an example of recovery control signals). A plurality of internal voltage IVC transistors may be included between the third node N3 and the internal voltage IVC supply or internal power terminal. The plurality of IVC transistors may be connected in parallel. The plurality of IVC transistors may provide the internal voltage IVC to the third node N3 according to the IVC control signals C1 to Cr (which are an example of recovery control signals).

The plurality of EVC transistors and the plurality of IVC transistors may be used to adjust the rising slope of the recovery voltage. The read recovery voltage controller 2000 may provide EVC control signals B1 to Bq and/or IVC control signals C1 to Cr to the read recovery voltage generator 1155 during the recovery operation. The read recovery voltage generator 1155 may control the rising slope of the recovery voltage provided to the selected word line sWL and/or unselected word lines uWL during the recovery operation period. In some example embodiments, q may be greater than, less than, or equal to r. In some example embodiments, each of p, q, and r may be the same; however, example embodiments are not limited thereto.

The read recovery voltage controller 2000 may control a rising slope and/or a falling slope of the recovery voltage using recovery control signals. The read recovery voltage controller 2000 may reduce a residual voltage between a selected word line and unselected word lines after a recovery operation.

Each of the transistors, such as the first NMOS transistor NT1, the second NMOS transistor NT2, the third NMOS transistor NT3, the plurality of ground pass transistors, the plurality of EVC transistors, and the plurality of IVC transistors may be planar transistors and/or three-dimensional transistors, having the same or different electrical properties and/or physical properties. Example embodiments are not limited thereto.

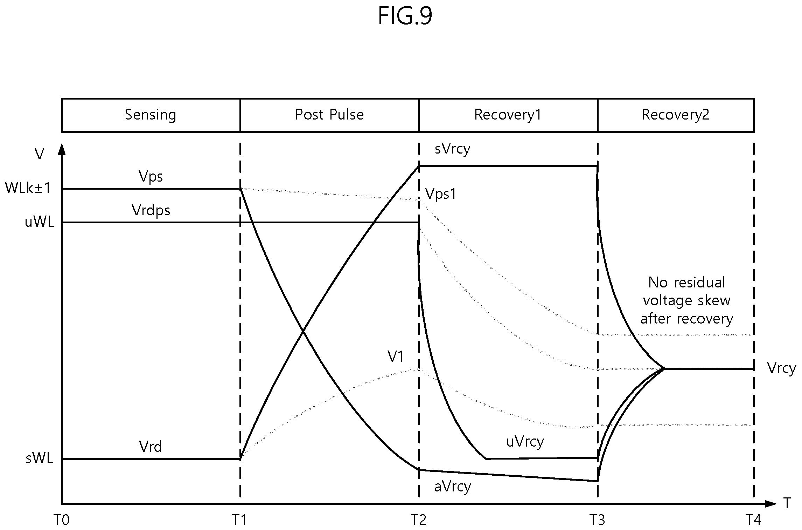

FIG. 9 is a timing diagram illustrating a read operation method of the flash memory illustrated in FIG. 1 according to various example embodiments. Referring to FIG. 9, the read operation of the flash memory 1100 may include, e.g., be partitioned into, a sensing period, a post pulse period, a first recovery period, and a second recovery period. The sensing period is a period T0 to T1, the post pulse period is a period T1 to T2, the first recovery period is a period T2 to T3, and the second recovery period is a period T3 to T4. For clarity, the timing diagram in FIG. 7 is illustrated as dashed-lines in FIG. 9.

In the sensing period, the selection read voltage Vrd may be applied to the selected word line sWL. The read pass voltage Vrdps may be applied to the unselected word lines uWL. The pass voltage Vps may be applied to the adjacent word line WLk+1 and/or WLk-1. A selection line voltage may be applied to the string selection line SSL and the ground selection line GSL. The selection line voltage may be a voltage sufficient to turn on the string selection transistor SST and/or the ground selection transistor GST.

In the post pulse period, the selection read voltage Vrd provided to the selected word line sWL may rise to the selection recovery voltage sVrcy. The selection recovery voltage sVrcy may be higher than the first voltage V1 described with reference to FIG. 6. The read pass voltage Vrdps may be applied to the unselected word line uWL. The pass voltage Vps may be applied to the adj acent word line WLk+1 and/or WLk-1. The voltage level of the adjacent word lines may drop to the adjacent recovery voltage aVrcy. The adjacent recovery voltage aVrcy may be lower than the first pass voltage Vps1 described with reference to FIG. 6.

In the first recovery period, the selection line voltage may be maintained on the string selection line SSL and the ground selection line GSL. The selection recovery voltage sVrcy may be continuously applied to the selected word line sWL. A voltage level of the unselected word lines uWL may drop to the unselection recovery voltage uVrcy. The adjacent word line WLk+1 and/or WLk-1 may maintain the adjacent recovery voltage aVrcy or may drop by a level, such as a dynamically determined or predetermined level.

Read recovery voltage generators having the same configuration and operating principle as the read recovery voltage generator 1155 illustrated in FIG. 8 may also be connected to the unselected word lines uWL. The read recovery voltage generators connected to the unselected word lines uWL may include a plurality of ground pass transistors. The plurality of ground pass transistors may be used to adjust the falling slope of the unselection recovery voltage uVrcy. The read recovery voltage controller 2000 may control the falling slope of the unselection recovery voltage uVrcy by adjusting the number of ground pass transistors having discharge paths to the ground terminal.

In the second recovery period, the voltage level of the selected word line sWL may drop from the selection recovery voltage sVrcy to the recovery voltage Vrcy. A voltage level of the unselected word lines uWL may rise from the unselection recovery voltage uVrcy to the recovery voltage Vrcy. A voltage level of the adjacent word lines WLk+1 and/or WLk-1 may rise from the adjacent recovery voltage aVrcy to the recovery voltage Vrcy.

As illustrated in FIG. 9, the flash memory 1100 according to various example embodiment may reduce a residual voltage skew between the selected word line sWL and unselected word lines uWL after a recovery operation. In particular, the flash memory 1100 may reduce a residual voltage skew between the selected word line sWL and the adjacent word line WLk+1 and/or WLk-1. The flash memory 1100 may control a recovery voltage provided to a selected word line and/or unselected word lines during the read operation. The flash memory 1100 may reduce a residual voltage between the selected word line and unselected word lines after a recovery operation. The flash memory 1100 may reduce threshold voltage distortion due to residual voltage.

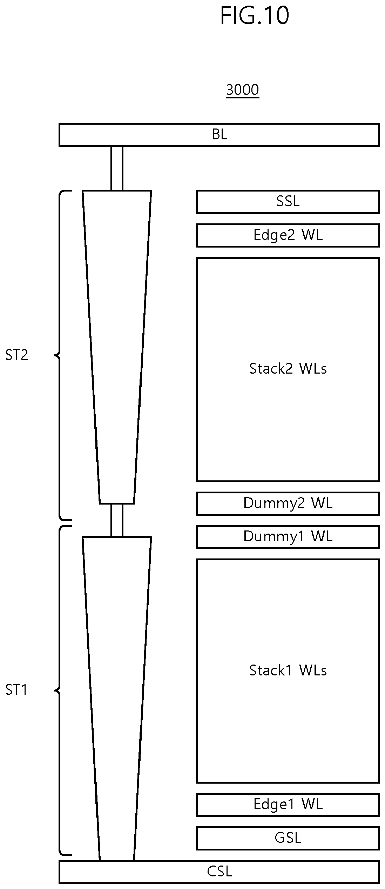

FIG. 10 is a diagram illustrating a flash memory 3000 having a multi-stack structure according to various example embodiments. Referring to FIG. 10, the flash memory 3000 may have a plurality of stacks such as a first stack ST1 and a second stack ST2. The first stack ST1 may be located at the bottom, and the second stack ST2 may be located at the top.

A pillar of the flash memory 3000 may be formed by bonding the first and second stacks ST1 and ST2. A plurality of dummy word lines (e.g., Dummy1 WL and Dummy2 WL) may be included at junctions of the first and second stacks ST1 and ST2. The first stack ST1 may be positioned between the common source line CSL and the first dummy word line Dummy1 WL. The second stack ST2 may be positioned between the second dummy word line Dummy2 WL and the bit line BL.

The first stack ST1 may include a ground selection line GSL, a first edge word line Edge1 WL, and first stack word lines Stack1 WLs. The second stack ST2 may include second stack word lines Stack2 WLs and second edge word lines Edge2 WL. The number of word lines in the first stack ST1 may be the same as, greater than, or less than, the number of word lines in the second stack ST2. Memory cells connected to the first and second edge word lines Edge1 WL and Edge2 WL may store bit data different from the other memory cells. For example, memory cells connected to the first and second edge word lines Edge1 WL and Edge2 WL may be SLC or MLC, and memory cells connected to the other word lines may be TLC or quad-level cells (QLC).

During a read operation, the flash memory 3000 may differently control a post pulse voltage and/or a recovery voltage according to the height of (e.g., a vertical height of) a word line. For example, the flash memory 3000 may reduce threshold voltage distortion due to HCI by reducing a residual voltage skew according to a height of a stack and/or a word line in the stack during a read recovery operation.

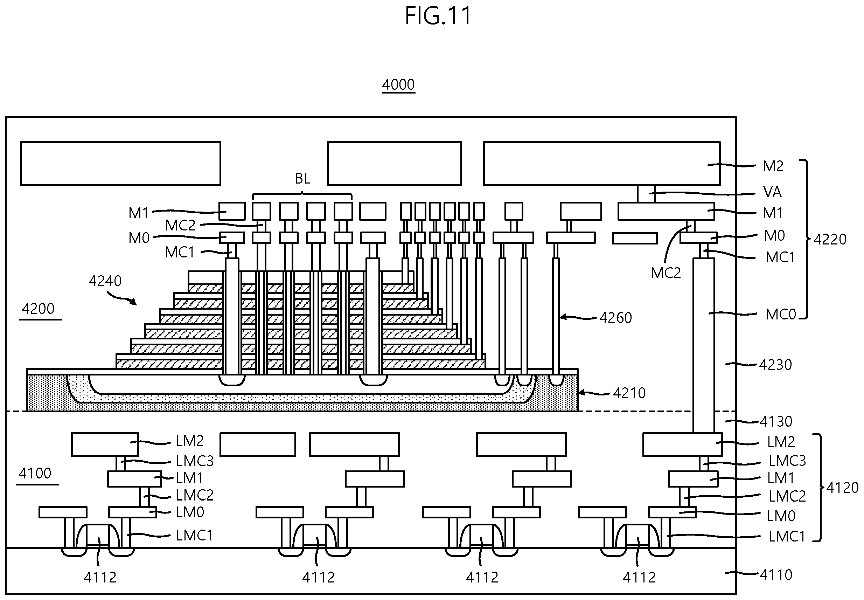

FIG. 11 is a cross-sectional view illustrating a flash memory having a COP structure according to various example embodiments. Referring to FIG. 11, the flash memory 4000 may have a cell-on-peripheral (COP) structure in which a memory cell area 4200 is stacked on a peripheral circuit area 4100. At least a portion of the peripheral circuit area 4100 and at least a portion of the memory cell area 4200 may vertically overlap.

The peripheral circuit area 4100 may include at least one peripheral transistor 4112 disposed on a lower substrate 4110, a peripheral circuit wiring 4120 electrically connected to the peripheral transistor 4112, and a lower insulating layer 4130 covering at least the peripheral circuit wiring 4120 and the peripheral transistor 4112. Meanwhile, the peripheral circuit area 4100 may include an active resistor array. The active resistor array may include an active resistor area and a selection transistor area. The active resistor array may be formed between the peripheral transistors 4112 of the lower substrate 4110, and the selection transistor area may be formed of the peripheral transistors 4112.

The memory cell area 4200 may include an upper substrate 4210, a cell array 4240 disposed on the upper substrate 4210, and an upper insulating layer 4230 covering the cell array 4240. The memory cell area 4200 may further include a connection circuit wiring 4220 electrically connecting the cell array 4240 and the peripheral circuit area wiring 4120. The cell array 4240 may include a metal contact 4260 electrically connecting the cell array 4240 to the connection circuit wiring 4220.

In the peripheral circuit area 4100, the lower substrate 4110 may include a semiconductor substrate (e.g., a silicon chip formed from or singulated from a silicon wafer). As an example, the peripheral circuit wiring 4120 may include a lower metal line LM0, an intermediate metal line LM1, and an upper metal line LM2, which are vertically stacked on and from the lower substrate 4110. The peripheral circuit wiring 4120 may further include a lower metal contact LMC1 electrically connecting the peripheral transistor 4112 with the lower metal line LM0, an intermediate metal contact LMC2 electrically connecting the lower metal line LM0 with the intermediate metal line LM1, and an upper metal contact LMC3 electrically connecting the intermediate metal line LM1 with the upper metal line LM2.

Although FIG. 11 illustrates three levels of metal lines LM0, LM1, and LM2, example embodiments are not limited thereto, and there may be more, or less, metal lines than illustrated. Furthermore, although FIG. 11 illustrates that the peripheral transistors 4112 are planar transistors extending into the drawing, example embodiments are not limited thereto. For example, at least one of the peripheral transistors 4112 may be a three-dimensional transistor and/or may extend parallel to the drawing.

In the memory cell area 4200, the cell array 4240 may have a three-dimensional structure in which a plurality of cells are vertically stacked on an upper substrate 4210 having a well structure. The metal contact 4260 may be provided to electrically connect the plurality of cells of the cell array 4240 to the connection circuit wiring 4220 of the upper substrate 4210.

The connection circuit wiring 4220 may be electrically connected to the peripheral circuit area wiring 4120. The connection circuit wire 4220 may include a lower metal wire M0, an intermediate metal wire M1, and an upper metal wire M2 sequentially stacked on the cell array 4240. The connection circuit wiring 4220 electrically connects the connection metal contact MC0 that electrically connects the peripheral circuit area wiring 4120 to the connection circuit wiring 4220, the connection metal contact MC0, and the lower metal wiring M0. A lower metal contact MC1 to electrically connect the lower metal wire M0 to the intermediate metal wire M1, and an intermediate metal contact MC2 to electrically connect the middle metal wire M1 to the upper metal wire M2. A via VA may be further included as an upper metal contact. The lower metal contact MC1 may connect the cell array 4240 to the intermediate metal line M0. The intermediate metal wiring M1 may include a bit line BL electrically connected to a vertical channel of the cell array 4240.

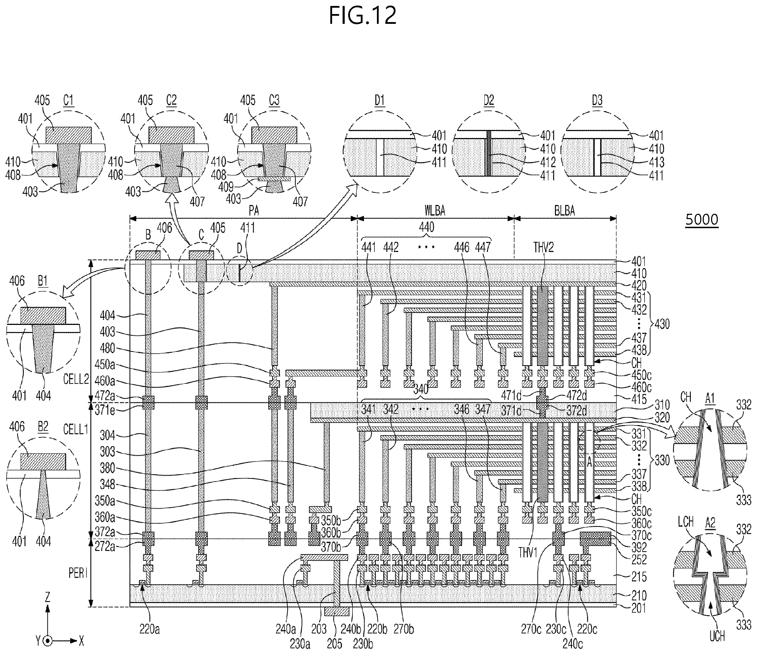

FIG. 12 is a view illustrating a memory device according to some embodiments. Referring to FIG. 12, the memory device 6000 may have a chip-to-chip (C2C) structure. At least one upper chip including a cell region and a lower chip including a peripheral circuit region PERI may be manufactured separately, and then, the at least one upper chip and the lower chip may be connected to each other by a bonding method to realize the C2C structure.

For example, the bonding method may mean a method of electrically or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively or additionally, the bonding metal patterns may be formed of aluminum (Al) or tungsten (W).

The memory device 6000 may include the at least one upper chip including the cell region. For example, the memory device 6000 may include two upper chips. However, the number of the upper chips is not limited thereto. In the case in which the memory device 6000 includes the two upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the memory device 6000. The first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. In other words, an upper portion of the lower chip may mean an upper portion defined based on a +Z-axis direction, and the upper portion of each of the first and second upper chips may mean an upper portion defined based on a -Z-axis direction. However, example embodiments are not limited thereto. In some embodiments of the first upper chip and the second upper chip may be turned over and then may be connected to a corresponding chip by the bonding method.

Each of the peripheral circuit region PERI and the first and second cell regions CELL1 and CELL2 of the memory device 6000 may include an external pad bonding region PA, a word line bonding region WLBA, and a bit line bonding region BLBA.

The peripheral circuit region PERI may include a first substrate 210 and a plurality of circuit elements 220a, 220b and 220c formed on the first substrate 210. An interlayer insulating layer 215 including one or more insulating layers may be provided on the plurality of circuit elements 220a, 220b and 220c, and a plurality of metal lines electrically connected to the plurality of circuit elements 220a, 220b and 220c may be provided in the interlayer insulating layer 215. For example, the plurality of metal lines may include first metal lines 230a, 230b and 230c connected to the plurality of circuit elements 220a, 220b and 220c, and second metal lines 240a, 240b and 240c formed on the first metal lines 230a, 230b and 230c. The plurality of metal lines may be formed of at least one of various conductive materials. For example, the first metal lines 230a, 230b and 230c may be formed of tungsten having a relatively high electrical resistivity, and the second metal lines 240a, 240b and 240c may be formed of copper having a relatively low electrical resistivity.

The first metal lines 230a, 230b and 230c and the second metal lines 240a, 240b and 240c are illustrated and described in the present embodiments. However, example embodiments are not limited thereto. In some example embodiments, at least one or more additional metal lines may further be formed on the second metal lines 240a, 240b and 240c. In this case, the second metal lines 240a, 240b and 240c may be formed of aluminum, and at least some of the additional metal lines formed on the second metal lines 240a, 240b and 240c may be formed of copper having an electrical resistivity lower than that of aluminum of the second metal lines 240a, 240b and 240c.

The interlayer insulating layer 215 may be disposed on the first substrate 210 and may include an insulating material such as silicon oxide and/or silicon nitride.

Each of the first and second cell regions CELL1 and CELL2 may include at least one memory block. The first cell region CELL1 may include a second substrate 310 and a common source line 320. A plurality of word lines 330 (331 to 338) may be stacked on the second substrate 310 in a direction (e.g., the Z-axis direction) perpendicular to a top surface of the second substrate 310. String selection lines and a ground selection line may be disposed on and under the word lines 330, and the plurality of word lines 330 may be disposed between the string selection lines and the ground selection line. Likewise, the second cell region CELL2 may include a third substrate 410 and a common source line 420, and a plurality of word lines 430 (431 to 438) may be stacked on the third substrate 410 in a direction (e.g., the Z-axis direction) perpendicular to a top surface of the third substrate 410. Each of the second substrate 310 and the third substrate 410 may be formed of at least one of various materials and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CELL1 and CELL2.

In some example embodiments, as illustrated in a region 'A1', the channel structure CH may be provided in the bit line bonding region BLBA and may extend in the direction perpendicular to the top surface of the second substrate 310 to penetrate the word lines 330, the string selection lines, and the ground selection line. The channel structure CH may include a data storage layer, a channel layer, and a filling insulation layer. The channel layer may be electrically connected to a first metal line 350c and a second metal line 360c in the bit line bonding region BLBA. For example, the second metal line 360c may be a bit line and may be connected to the channel structure CH through the first metal line 350c. The bit line 360c may extend in a first direction (e.g., a Y-axis direction) parallel to the top surface of the second substrate 310.

In some example embodiments, as illustrated in a region 'A2', the channel structure CH may include a lower channel LCH and an upper channel UCH, which are connected to each other. For example, the channel structure CH may be formed by a process of forming the lower channel LCH and a process of forming the upper channel UCH. The lower channel LCH may extend in the direction perpendicular to the top surface of the second substrate 310 to penetrate the common source line 320 and lower word lines 331 and 332. The lower channel LCH may include a data storage layer, a channel layer, and a filling insulation layer and may be connected to the upper channel UCH. The upper channel UCH may penetrate upper word lines 333 to 338. The upper channel UCH may include a data storage layer, a channel layer, and a filling insulation layer, and the channel layer of the upper channel UCH may be electrically connected to the first metal line 350c and the second metal line 360c. As a length of a channel increases, due to characteristics of manufacturing processes, it may be difficult to form a channel having a substantially uniform width. The memory device 6000 according to the present embodiments may include a channel having improved width uniformity due to the lower channel LCH and the upper channel UCH which are formed by the processes performed sequentially.

In the case in which the channel structure CH includes the lower channel LCH and the upper channel UCH as illustrated in the region `A2', a word line located near to a boundary between the lower channel LCH and the upper channel UCH may be a dummy word line. For example, the word lines 332 and 333 adjacent to the boundary between the lower channel LCH and the upper channel UCH may be the dummy word lines. In this case, data may not be stored in memory cells connected to the dummy word line. Alternatively, the number of pages corresponding to the memory cells connected to the dummy word line may be less than the number of pages corresponding to the memory cells connected to a general word line. A level of a voltage applied to the dummy word line may be different from a level of a voltage applied to the general word line, and thus it is possible to reduce an influence of a non-uniform channel width between the lower and upper channels LCH and UCH on an operation of the memory device.

The number of the lower word lines 331 and 332 penetrated by the lower channel LCH is less than the number of the upper word lines 333 to 338 penetrated by the upper channel UCH in the region 'A2'. However, example embodiments are not limited thereto. In some example embodiments, the number of the lower word lines penetrated by the lower channel LCH may be equal to or more than the number of the upper word lines penetrated by the upper channel UCH. In addition, structural features and connection relation of the channel structure CH disposed in the second cell region CELL2 may be substantially the same as those of the channel structure CH disposed in the first cell region CELL1.

In the bit line bonding region BLBA, a first through-electrode THV1 may be provided in the first cell region CELL1, and a second through-electrode THV2 may be provided in the second cell region CELL2. The first through-electrode THV1 may penetrate the common source line 320 and the plurality of word lines 330. In some embodiments, the first through-electrode THV1 may further penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some example embodiments, the first through-electrode THV1 and the second through-electrode THV2 may be electrically connected to each other through a first through-metal pattern 372d and a second through-metal pattern 472d. The first through-metal pattern 372d may be formed at a bottom end of the first upper chip including the first cell region CELL1, and the second through-metal pattern 472d may be formed at a top end of the second upper chip including the second cell region CELL2. The first through-electrode THV1 may be electrically connected to the first metal line 350c and the second metal line 360c. A lower via 371d may be formed between the first through-electrode THV1 and the first through-metal pattern 372d, and an upper via 471d may be formed between the second through-electrode THV2 and the second through-metal pattern 472d. The first through-metal pattern 372d and the second through-metal pattern 472d may be connected to each other by the bonding method.

In addition, in the bit line bonding region BLBA, an upper metal pattern 252 may be formed in an uppermost metal layer of the peripheral circuit region PERI, and an upper metal pattern 392 having the same shape as the upper metal pattern 252 may be formed in an uppermost metal layer of the first cell region CELL1. The upper metal pattern 392 of the first cell region CELL1 and the upper metal pattern 252 of the peripheral circuit region PERI may be electrically connected to each other by the bonding method. In the bit line bonding region BLBA, the bit line 360c may be electrically connected to a page buffer included in the peripheral circuit region PERI. For example, some of the circuit elements 220c of the peripheral circuit region PERI may constitute the page buffer, and the bit line 360c may be electrically connected to the circuit elements 220c constituting the page buffer through an upper bonding metal pattern 370c of the first cell region CELL1 and an upper bonding metal pattern 270c of the peripheral circuit region PERI.

In the word line bonding region WLBA, the word lines 330 of the first cell region CELL1 may extend in a second direction (e.g., an X-axis direction) parallel to the top surface of the second substrate 310 and may be connected to a plurality of cell contact plugs 340 (341 to 347). First metal lines 350b and second metal lines 360b may be sequentially connected onto the cell contact plugs 340 connected to the word lines 330. In the word line bonding region WLBA, the cell contact plugs 340 may be connected to the peripheral circuit region PERI through upper bonding metal patterns 370b of the first cell region CELL1 and upper bonding metal patterns 270b of the peripheral circuit region PERI.

The cell contact plugs 340 may be electrically connected to a row decoder included in the peripheral circuit region PERI. For example, some of the circuit elements 220b of the peripheral circuit region PERI may constitute the row decoder, and the cell contact plugs 340 may be electrically connected to the circuit elements 220b constituting the row decoder through the upper bonding metal patterns 370b of the first cell region CELL1 and the upper bonding metal patterns 270b of the peripheral circuit region PERI. In some embodiments, an operating voltage of the circuit elements 220b constituting the row decoder may be different from an operating voltage of the circuit elements 220c constituting the page buffer. For example, the operating voltage of the circuit elements 220c constituting the page buffer may be greater than the operating voltage of the circuit elements 220b constituting the row decoder.

Likewise, in the word line bonding region WLBA, the word lines 430 of the second cell region CELL2 may extend in the second direction (e.g., the X-axis direction) parallel to the top surface of the third substrate 410 and may be connected to a plurality of cell contact plugs 440 (441 to 447). The cell contact plugs 440 may be connected to the peripheral circuit region PERI through an upper metal pattern of the second cell region CELL2 and lower and upper metal patterns and a cell contact plug 348 of the first cell region CELL 1.

In the word line bonding region WLBA, the upper bonding metal patterns 370b may be formed in the first cell region CELL1, and the upper bonding metal patterns 270b may be formed in the peripheral circuit region PERI. The upper bonding metal patterns 370b of the first cell region CELL1 and the upper bonding metal patterns 270b of the peripheral circuit region PERI may be electrically connected to each other by the bonding method. The upper bonding metal patterns 370b and the upper bonding metal patterns 270b may be formed of aluminum, copper, or tungsten.

In the external pad bonding region PA, a lower metal pattern 371e may be formed in a lower portion of the first cell region CELL1, and an upper metal pattern 472a may be formed in an upper portion of the second cell region CELL2. The lower metal pattern 371e of the first cell region CELL1 and the upper metal pattern 472a of the second cell region CELL2 may be connected to each other by the bonding method in the external pad bonding region PA. Likewise, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 and the upper metal pattern 272a of the peripheral circuit region PERI may be connected to each other by the bonding method.

Common source line contact plugs 380 and 480 may be disposed in the external pad bonding region PA. The common source line contact plugs 380 and 480 may be formed of a conductive material such as a metal, a metal compound, and/or doped polysilicon. The common source line contact plug 380 of the first cell region CELL1 may be electrically connected to the common source line 320, and the common source line contact plug 480 of the second cell region CELL2 may be electrically connected to the common source line 420. A first metal line 350a and a second metal line 360a may be sequentially stacked on the common source line contact plug 380 of the first cell region CELL1, and a first metal line 450a and a second metal line 460a may be sequentially stacked on the common source line contact plug 480 of the second cell region CELL2.

Input/output pads 205, 405 and 406 may be disposed in the external pad bonding region PA. A lower insulating layer 201 may cover a bottom surface of the first substrate 210, and a first input/output pad 205 may be formed on the lower insulating layer 201. The first input/output pad 205 may be connected to at least one of a plurality of the circuit elements 220a disposed in the peripheral circuit region PERI through a first input/output contact plug 203 and may be separated from the first substrate 210 by the lower insulating layer 201. In addition, a side insulating layer may be disposed between the first input/output contact plug 203 and the first substrate 210 to electrically isolate the first input/output contact plug 203 from the first substrate 210.

An upper insulating layer 401 covering a top surface of the third substrate 410 may be formed on the third substrate 410. A second input/output pad 405 and/or a third input/output pad 406 may be disposed on the upper insulating layer 401. The second input/output pad 405 may be connected to at least one of the plurality of circuit elements 220a disposed in the peripheral circuit region PERI through second input/output contact plugs 403 and 303, and the third input/output pad 406 may be connected to at least one of the plurality of circuit elements 220a disposed in the peripheral circuit region PERI through third input/output contact plugs 404 and 304.

In some example embodiments, the third substrate 410 may not be disposed in a region in which the input/output contact plug is disposed. For example, as illustrated in a region 'B', the third input/output contact plug 404 may be separated from the third substrate 410 in a direction parallel to the top surface of the third substrate 410 and may penetrate an interlayer insulating layer 415 of the second cell region CELL2 so as to be connected to the third input/output pad 406. In this case, the third input/output contact plug 404 may be formed by at least one of various processes.

In some example embodiments, as illustrated in a region 'B1', the third input/output contact plug 404 may extend in a third direction (e.g., the Z-axis direction), and a diameter of the third input/output contact plug 404 may become progressively greater toward the upper insulating layer 401. In other words, a diameter of the channel structure CH described in the region 'A1' may become progressively less toward the upper insulating layer 401, but the diameter of the third input/output contact plug 404 may become progressively greater toward the upper insulating layer 401. For example, the third input/output contact plug 404 may be formed after the second cell region CELL2 and the first cell region CELL1 are bonded to each other by the bonding method.

In some example embodiments, as illustrated in a region 'B2', the third input/output contact plug 404 may extend in the third direction (e.g., the Z-axis direction), and a diameter of the third input/output contact plug 404 may become progressively less toward the upper insulating layer 401. For example, like the channel structure CH, the diameter of the third input/output contact plug 404 may become progressively less toward the upper insulating layer 401. For example, the third input/output contact plug 404 may be formed together with the cell contact plugs 440 before the second cell region CELL2 and the first cell region CELL1 are bonded to each other.

In some example embodiments, the input/output contact plug may overlap with the third substrate 410. For example, as illustrated in a region 'C', the second input/output contact plug 403 may penetrate the interlayer insulating layer 415 of the second cell region CELL2 in the third direction (e.g., the Z-axis direction) and may be electrically connected to the second input/output pad 405 through the third substrate 410. In this case, a connection structure of the second input/output contact plug 403 and the second input/output pad 405 may be realized by various methods.

In some example embodiments, as illustrated in a region 'C1', an opening 408 may be formed to penetrate the third substrate 410, and the second input/output contact plug 403 may be connected directly to the second input/output pad 405 through the opening 408 formed in the third substrate 410. In this case, as illustrated in the region 'C1', a diameter of the second input/output contact plug 403 may become progressively greater toward the second input/output pad 405. However, embodiments of the inventive concepts are not limited thereto, and in some embodiments, the diameter of the second input/output contact plug 403 may become progressively less toward the second input/output pad 405.

In some example embodiments, as illustrated in a region 'C2', the opening 408 penetrating the third substrate 410 may be formed, and a contact 407 may be formed in the opening 408. An end of the contact 407 may be connected to the second input/output pad 405, and another end of the contact 407 may be connected to the second input/output contact plug 403. Thus, the second input/output contact plug 403 may be electrically connected to the second input/output pad 405 through the contact 407 in the opening 408. In this case, as illustrated in the region 'C2', a diameter of the contact 407 may become progressively greater toward the second input/output pad 405, and a diameter of the second input/output contact plug 403 may become progressively less toward the second input/output pad 405. For example, the second input/output contact plug 403 may be formed together with the cell contact plugs 440 before the second cell region CELL2 and the first cell region CELL1 are bonded to each other, and the contact 407 may be formed after the second cell region CELL2 and the first cell region CELL1 are bonded to each other.

In some example embodiments illustrated in a region 'C3', a stopper 409 may further be formed on a bottom end of the opening 408 of the third substrate 410, as compared with the embodiments of the region 'C2'. The stopper 409 may be a metal line formed in the same layer as the common source line 420. Alternatively, the stopper 409 may be a metal line formed in the same layer as at least one of the word lines 430. The second input/output contact plug 403 may be electrically connected to the second input/output pad 405 through the contact 407 and the stopper 409.

Like the second and third input/output contact plugs 403 and 404 of the second cell region CELL2, a diameter of each of the second and third input/output contact plugs 303 and 304 of the first cell region CELL1 may become progressively less toward the lower metal pattern 371e or may become progressively greater toward the lower metal pattern 371e.

In some example embodiments, a slit 411 may be formed in the third substrate 410. For example, the slit 411 may be formed at a certain position of the external pad bonding region PA. For example, as illustrated in a region 'D', the slit 411 may be located between the second input/output pad 405 and the cell contact plugs 440 when viewed in a plan view. Alternatively, the second input/output pad 405 may be located between the slit 411 and the cell contact plugs 440 when viewed in a plan view.

In some example embodiments, as illustrated in a region 'D1', the slit 411 may be formed to penetrate the third substrate 410. For example, the slit 411 may be used to prevent the third substrate 410 from being finely cracked when the opening 408 is formed. However, example embodiments are not limited thereto, and in some example embodiments, the slit 411 may be formed to have a depth ranging from about 60% to about 70% of a thickness of the third substrate 410.

In some example embodiments, as illustrated in a region 'D2', a conductive material 412 may be formed in the slit 411. For example, the conductive material 412 may be used to discharge a leakage current occurring in driving of the circuit elements in the external pad bonding region PA to the outside. In this case, the conductive material 412 may be connected to an external ground line.

In some example embodiments, as illustrated in a region 'D3', an insulating material 413 may be formed in the slit 411. For example, the insulating material 413 may be used to electrically isolate the second input/output pad 405 and the second input/output contact plug 403 disposed in the external pad bonding region PA from the word line bonding region WLBA. Since the insulating material 413 is formed in the slit 411, it is possible to prevent a voltage provided through the second input/output pad 405 from affecting a metal layer disposed on the third substrate 410 in the word line bonding region WLBA.

In some example embodiments, the first to third input/output pads 205, 405 and 406 may be selectively formed. For example, the memory device 6000 may be realized to include only the first input/output pad 205 disposed on the first substrate 210, to include only the second input/output pad 405 disposed on the third substrate 410, or to include only the third input/output pad 406 disposed on the upper insulating layer 401.

In some example embodiments, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the bonding process of the peripheral circuit region PERI and the first cell region CELL1, and then, an insulating layer covering a top surface of the common source line 320 or a conductive layer for connection may be formed. Likewise, the third substrate 410 of the second cell region CELL2 may be removed before or after the bonding process of the first cell region CELL1 and the second cell region CELL2, and then, the upper insulating layer 401 covering a top surface of the common source line 420 or a conductive layer for connection may be formed.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

While various example embodiments have been described, it will be apparent to those of ordinary skill in the art that various changes and modifications may be made thereto without departing from the scope as set forth in the following claims. Furthermore, example embodiments are not necessarily mutually exclusive with one another. For example, some example embodiments may include one or more features described with reference to one or more figures, and may also include one or more other features described with reference to one or more other figures.

## Claims

1. A flash memory comprising:
a memory cell array (1110) having a plurality of memory cells (MC1 to MCm);
a read recovery voltage generator (1155) configured to provide a read recovery voltage to the plurality of memory cells (MC1 to MCm); and
a read recovery voltage controller (2000) configured to provide recovery control signals (A1 to Ap) for controlling the read recovery voltage (Vrcv),
wherein the read recovery voltage generator (1155) includes a plurality of ground pass transistors that, during a read recovery operation (Recovery 1, Recovery2), are configured to control a falling slope of an unselection recovery voltage (uVrcv) provided to an unselected word line (uWL) in response to the recovery control signals (A1 to Ap).

2. The flash memory of claim 1, wherein
the plurality of ground pass transistors are connected in parallel between the unselected word line (uWL) and a ground terminal (GND), and
the read recovery voltage controller (2000) is configured to control the falling slope of the unselection recovery voltage (uVrcv) by providing ground control signals (A1 to Ap) to gates of respective ground pass transistors.

3. The flash memory of claim 2, wherein the read recovery voltage controller (2000) is configured to control the falling slope of the unselection recovery voltage (uVrcv) by adjusting a number of ground pass transistors having discharge paths to the ground terminal (GND).

4. The flash memory of any one of claims 1 to 3, wherein the read recovery voltage generator (1155) includes a plurality of power transistors that, during a read recovery operation (Recovery 1, Recovery2), are configured to control a rising slope of an unselection recovery voltage (uVrcv) provided to the unselected word line (uWL) in response to the recovery control signals (B1 to Bq; C1 to Cr).

5. The flash memory of claim 4, wherein
the plurality of power transistors are connected in parallel between the unselected word line (uWL) and a power terminal (EVC; IVC), and
the read recovery voltage controller (2000) is configured to control the rising slope of the unselection recovery voltage (uVrcv) by providing power control signals (B1 to Bq; C1 to Cr) to gates of the respective power transistors.

6. The flash memory of claim 5, wherein the read recovery voltage controller (2000) is configured to control the rising slope of the unselection recovery voltage (uVrcv) by adjusting a number of power transistors having current paths to the power terminal (EVC; IVC).

7. The flash memory of claim 5 or 6, wherein
the power terminal (EVC) includes an external power terminal (EVC), and
the read recovery voltage controller (2000) is configured to control the rising slope of the unselection recovery voltage (uVrcv) by providing external power control signals (B1 to Bq) to gates of the respective power transistors.

8. The flash memory of any one of claims 5 to 7, wherein
the power terminal (IVC) includes an internal power (IVC) terminal, and
the read recovery voltage controller (2000) is configured to control the rising slope of the unselection recovery voltage (uVrcv) by providing internal power control signals (C1 to Cr) to gates of respective power transistors.

9. The flash memory of any one of claims 1 to 8, wherein the read recovery voltage controller (2000) is configured to differently control the falling slope of the unselection recovery voltage (uVrcv) according to a mat (MAT1, ..., MAT4) of the memory cell array (1110).

10. The flash memory of any one of claims 1 to 9, wherein the read recovery voltage controller (2000) is configured to differently control the falling slope of the unselection recovery voltage (uVrcv) according to a height of word lines (WL1 to WLm) of the memory cell array (1110).

11. A flash memory comprising:
a memory cell array (1110) having a plurality of memory cells (MC1 to MCm);
a read recovery voltage generator (1155) configured to provide a read recovery voltage to the plurality of memory cells (MC1 to MCm); and
a read recovery voltage controller (2000) configured to provide recovery control signals (A1 to Ap, B1 to Bq, C1 to Cr) for controlling the read recovery voltage (Vrcv),
wherein the read recovery voltage generator (1155) includes a plurality of transistors that are configured to control a slope of a recovery voltage (Vrcv) provided to a word line in response to the recovery control signals (A1 to Ap, B1 to Bq, C1 to Cr) during a read recovery operation (Recovery 1, Recovery2), and
the read recovery voltage controller (2000) is configured to control a slope of a selection recovery voltage (sVrcv) provided to a selected word line (sWL; WLk) and an unselection recovery voltage (uVrcv) provided to unselected word lines (uWL) to be different.

12. The flash memory of claim 11, wherein the read recovery voltage generator (1155) includes a plurality of ground pass transistors that are configured to control a falling slope of the recovery voltage (Vrcv) provided to the word line (WLk) in response to the recovery control signals (A1 to Ap) during a read recovery operation (Recovery 1, Recovery2).

13. The flash memory of claim 12, wherein
the plurality of ground pass transistors are connected in parallel between the word line (WLk) and a ground terminal (GND), and
the read recovery voltage controller (2000) is configured to control the falling slope of the recovery voltage (Vrcv) by providing ground control signals (A1 to Ap) to gates of respective ground pass transistors.

14. The flash memory of claim 13, wherein the read recovery voltage generator (1155) includes a plurality of power transistors that, during a read recovery operation (Recovery 1, Recovery2), are configured to control a rising slope of the recovery voltage (Vrcv) provided to the word line (WLk) in response to the recovery control signals (B1 to Bq; C1 to Cr).

15. The flash memory of claim 14, wherein
the plurality of power transistors are connected in parallel between the word line (WLk) and a power terminal (EVC, IVC), and
the read recovery voltage controller (2000) is configured to control the rising slope of the recovery voltage (Vrcv) by providing power control signals (B1 to Bq; C1 to Cr) to the gate of each power transistor.
